# EUROPEAN PATENT APPLICATION

(11) **EP 4 239 669 A1**
(43) Date of publication of application: **06.09.2023**
(21) Application number: 21885864.5
(22) Date of filing: 08.10.2021
(51) Int. Cl.: H01L 23/14, H01L 23/29, H01L 23/31

(54) **SEMICONDUCTOR DEVICE AND MANUFACTURING METHOD FOR SAME**

(30) Priority: 29.10.2020 JP 2020181861
(71) Applicant: The University of Tokyo, Bunkyo-ku, Tokyo 113-8654 (JP); Pi-Crystal Inc., Chiba 277-0005 (JP); Organo-Circuit Incorporation, Kashiwa-shi, Chiba 277-8520 (JP)
(72) Inventor: TAKEYA, Junichi, Tokyo 113-8654 (JP); WATANABE, Kazuyoshi, Tokyo 113-8654 (JP); NOZAWA, Han, Kashiwa-shi, Chiba 277-0005 (JP); ONO, Yuichi, Kashiwa-shi, Chiba 2778520 (JP)
(74) Representative: Grünecker Patent- und Rechtsanwälte PartG mbB
(86) International application number: PCT/JP2021/037266
(87) International publication number: WO 2022/091745

(57) **Abstract**

Provided is a semiconductor device and a method of manufacturing the semiconductor device that is capable of improving the connection reliability between an electronic element and a substrate in a semiconductor device in which the electronic element is fixed to the substrate. The semiconductor device includes: a substrate 10 provided with wirings and wiring connection parts 12 connected to the wirings; electronic elements 20, 30, 40, and 50 electrically connected to the wiring connection parts 12 and fixed to the substrate; and a resin film 60 laminated on one surface of the substrate 10, conforming to the shapes of the electronic elements 20, 30, 40, and 50, and covering the electronic elements 20, 30, 40, and 50.

## Description

### Technical Field

The present invention relates to a semiconductor device and a method of manufacturing the semiconductor device.

### Background Art

The concept of the Internet of Things (IoT) has been proposed, and the advent of a networked society in which a sensor device is mounted on everything is foreseen. Such an IoT society requires inexpensive and mass-producible devices, and those regarded as promising core elements are organic thin film transistors (OTFTs) formed using an organic semiconductor (OSC). Compared to silicon semiconductors, which require a vacuum process, OSCs, which can be formed into a film by a low-cost printing method, have excellent processability. In addition, the transistor can operate with an ultra-thin film of several molecular layers, thus reducing the material cost. Furthermore, OSCs are known to also have flexibility resistant to mechanical stresses, such as bending or strain, and in addition, a minute change in transistor characteristics associated with this is known to be applicable to sensing. From such cost and functional merits, OTFTs are expected to greatly contribute to the realization of IoT society.

A semiconductor device includes various electronic elements, such as an OTFT, fixed to a substrate and electrically connected to each other by wiring. A typical reflow process of electrically connecting electronic elements on a substrate includes: a first stage in which wiring is patterned on the substrate by vapor deposition, plating, printing, or the like; a second stage in which a solder paste is printed; a third stage in which electronic elements are mounted; and a fourth stage in which the solder is melted by heating to establish conduction between the electronic elements and the wiring.

Patent Document 1 discloses a method of forming a layer of a solder paste by screen printing on an upper surface of an electrode formed on a substrate.

Patent Document 2 discloses a method of applying a solder paste into a through hole of a flexible printed circuit board by screen printing.

### Citation List

### Patent Document

Patent Document 1: JP 2019-051667 A
Patent Document 2: JP 2016-127205 A

### Summary of Invention

### Technical Problem

In the semiconductor device described above in which electronic elements are fixed to a substrate, the electrical connections between the electronic elements and the substrate may be impaired when, for example, the substrate is bent, vibration is applied to the substrate, or the electronic elements are scratched by external force. In particular, when the substrate is a flexible substrate, the semiconductor device can be easily affected by the bending of the substrate and/or the vibration of the substrate.

In the present specification, connection reliability between an electronic element and a substrate is referred to as "bending resistance" when the substrate is bent, "vibration resistance" when vibration is applied to the substrate, and "scratch resistance" when the electronic element is scratched.

The present invention has been made in view of the above circumstances, and an object of the present invention is to provide a semiconductor device and a method of manufacturing the semiconductor device that is capable of improving the connection reliability between an electronic element and a substrate in a semiconductor device in which the electronic element is fixed to the substrate.

### Solution to Problem

A semiconductor device according to an embodiment of the present invention includes: a substrate provided with a wiring and a wiring connection part connected to the wiring; an electronic element electrically connected to the wiring connection part and fixed to the substrate; and a resin film laminated on one surface of the substrate, the resin film conforming to a shape of the electronic element and covering the electronic element.

A method of manufacturing a semiconductor device according to an embodiment of the present invention includes: providing a substrate with a wiring and a wiring connection part connected to the wiring; electrically connecting an electronic element to the wiring connection part and fixing the electronic element to the substrate; and laminating a resin film on one surface of the substrate, conforming to a shape of the electronic element and covering the electronic element.

### Advantageous Effects of Invention

An embodiment of the present invention is capable of improving the connection reliability between the electronic element and the substrate in the semiconductor device in which the electronic element is fixed to the substrate.

### Brief Description of Drawings

FIG. 1 is a plan view of a semiconductor device according to a first embodiment.
FIG. 2 is a cross-sectional view taken along the line A-A' of FIG. 1.
FIG. 3 is a cross-sectional view illustrating a process in a method of manufacturing the semiconductor device of the first embodiment.
FIG. 4 is a cross-sectional view illustrating a process following FIG. 3.
FIG. 5 is a cross-sectional view illustrating a process following FIG. 4.
FIG. 6 is a cross-sectional view illustrating a process following FIG. 5.
FIG. 7 is a cross-sectional view of a semiconductor device according to a second embodiment.
FIG. 8 is a cross-sectional view illustrating a process in a method of manufacturing the semiconductor device of the second embodiment.
FIG. 9 is a cross-sectional view illustrating a process in a method of manufacturing a semiconductor device of a first modified example.
FIG. 10 is a cross-sectional view illustrating a process in a method of manufacturing a semiconductor device of a second modified example.

### Description of Embodiments

### First embodiment

### Overall configuration of semiconductor device

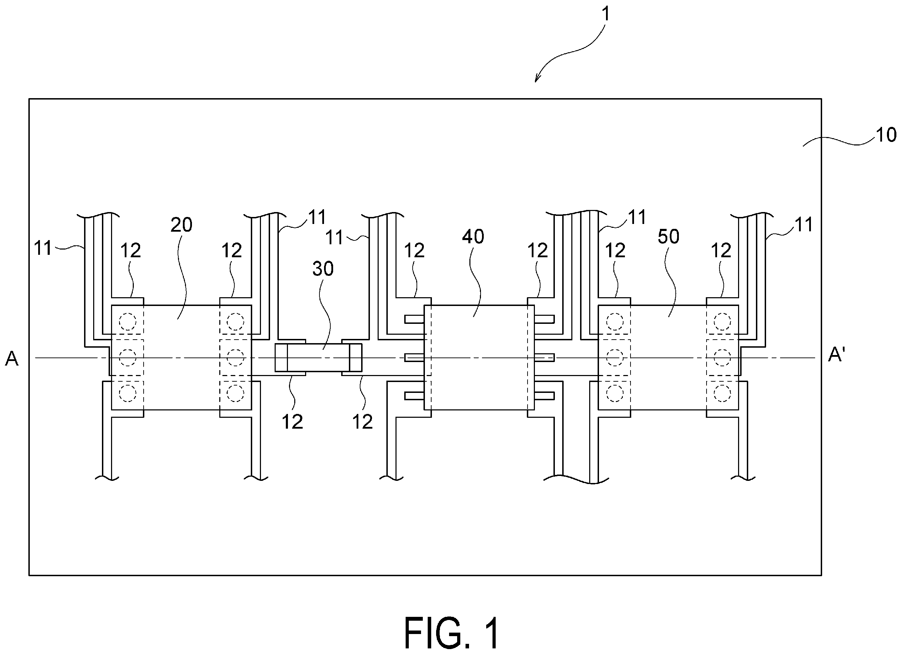

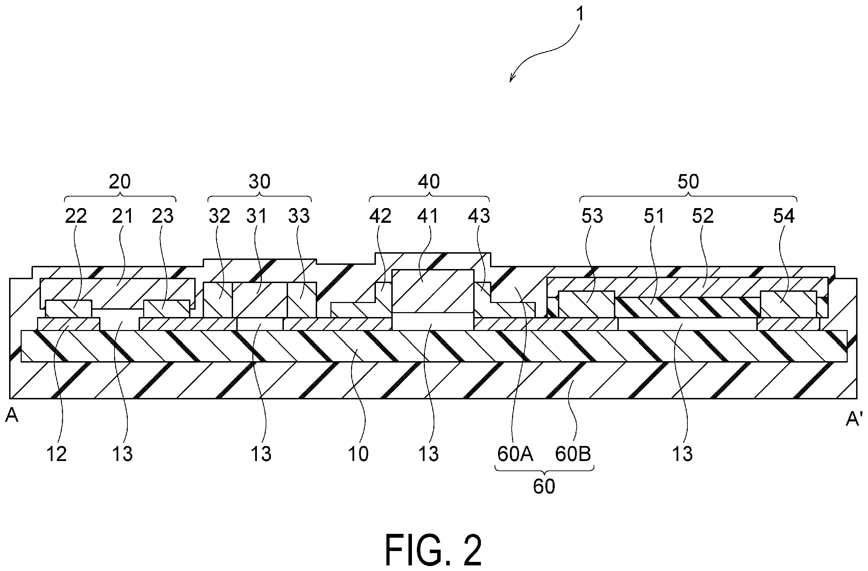

FIG. 1 is a plan view of a semiconductor device according to the present embodiment. FIG. 2 is a cross-sectional view taken along the line A-A' of FIG. 1. A semiconductor device 1 includes a substrate 10, electronic elements 20, 30, 40, and 50, and a resin film 60.

### Substrate

On the substrate 10, wirings 11 and wiring connection parts 12 are formed. The substrate 10 is, for example, a flexible substrate. The thickness of the substrate 10 is, for example, 10 µm or greater and 300 µm or less. The substrate 10 is formed, for example, of polyimide (PI). Alternatively, the substrate 10 is formed of a general-purpose resin film, such as polyethylene naphthalate (PEN), polyethylene terephthalate (PET), polylactic acid (PLA), an epoxy resin, or an acrylic resin, which has a lower thermal resistance than polyimide. Here, the substrate 10 is not limited to a single-layer substrate. The substrate 10 may be a multilayer wiring substrate in which a plurality of flexible substrates, each of which having at least the wiring 11 formed thereon, are laminated. In addition, in place of laminating a plurality of flexible substrates, the substrate 10 may also be a multilayer wiring substrate in which a plurality of conductive layers and insulating layers are laminated alternately on a single layer substrate. When the substrate 10 is a multilayer wiring substrate, the wiring connection part 12 is preferably formed in addition to the wiring 11 at least on a flexible substrate laminated as the uppermost layer among a plurality of the laminated flexible substrates.

### Wiring and wiring connection part

The wirings 11 and the wiring connection parts 12 connected to the wirings 11 are provided on the substrate 10. The wirings 11 and the wiring connection parts 12 are formed of the same material and are further formed, for example, with the same thickness (height). The wirings 11 and the wiring connection parts 12 are formed, for example, simultaneously by one manufacturing process. When the wirings 11 and the wiring connection parts 12 are formed simultaneously by one manufacturing process, the wirings 11 and the wiring connection parts 12 are formed of the same material and have the same thickness (height). The wirings 11 and the wiring connection parts 12 are obtained, for example, by printing a conductive paste at a predetermined thickness of 1 µm or greater and 300 µm or less in a predetermined wiring pattern and curing such a conductive paste. The conductive paste is formed by dispersing a conductive filler in an organic-based dispersion medium, such as a binder resin, or a water-based dispersion medium, such as a silicate aqueous solution, and is cured by firing, light irradiation, or drying, and can be used as a conductive layer. Examples of the conductive filler that can be used include metal particles, such as those of silver, copper, or nickel; and carbon blacks, such as those of a carbon flake, a carbon particle, or a carbon nanotube. The average particle size of the conductive filler is, for example, 0.1 µm or greater and several tens of micrometers or less. The accuracy of line/space by screen printing is, for example, an L/S of 50 µm/50 µm.

The conductive paste to be used in the wirings 11 and the wiring connection parts 12 of the present embodiment is not particularly limited to the following but has a curing temperature of 130°C or lower and more preferably 100°C or lower. With this configuration, when a flexible substrate is used as the substrate 10 or also when an organic semiconductor element is mounted as the electronic element 50, the wiring connection parts 12 and the electronic element 50 can be connected without damage to the substrate 10 and the electronic element 50.

### Electronic element

The electronic elements 20, 30, 40, and 50 are electrically connected to the wiring connection parts 12 and fixed to the substrate 10. The electronic elements 20, 30, 40, and 50 may each be either an active element or a passive element, an example of the active element including a transistor and an integrated circuit, and an example of the passive element including a resistance element and a sensor. The electronic elements 20, 30, 40, and 50 may include an active element and a passive element. In FIG. 1 and FIG. 2, the electronic elements 20, 40, and 50 represent active elements, and the electronic element 30 represents a passive element. The semiconductor device may be configured to include a plurality of electronic elements as illustrated in FIG. 1 and FIG. 2 but may also be configured to include only one electronic element.

The electronic elements 20, 30, 40, and 50 may each be either an inorganic semiconductor element, which is formed of silicon or the like, or an organic semiconductor element formed of an organic material. In FIG. 1 and FIG. 2, the electronic elements 20, 30, and 40 represent inorganic semiconductor elements, and the electronic element 50 represents an organic semiconductor element.

### Inorganic semiconductor element

The electronic element 20 includes a semiconductor element 21. The semiconductor element 21 is an inorganic semiconductor element containing an active element and includes, for example, a metal-oxide-semiconductor (MOS) transistor configured by laminating a gate electrode via a gate insulating film in an active region provided in a silicon semiconductor region and forming a source drain region in the silicon semiconductor region to sandwich the active region at both sides of the gate electrode. The semiconductor element 21 may be configured to include a thin film transistor (TFT) in which the silicon semiconductor region is a thin film semiconductor layer provided on a supporting substrate. Raised electrodes 22 and 23, such as bumps, are formed to be connected to the semiconductor element 21. For the electrodes 22 and 23, an example with six electrodes is illustrated in the drawing, but the number of the electrodes is freely selected. The outermost layer of the semiconductor element 21 is sealed with a sealing layer (not shown) containing an epoxy resin or the like except for the portions of the electrodes 22 and 23. The electrodes 22 and 23 are electrically connected and fixed to the wiring connection parts 12.

The electronic element 30 includes a semiconductor element 31. The semiconductor element 31 is an inorganic semiconductor element containing a passive element and includes, for example, a resistance element containing a resistance region provided in a silicon semiconductor region. Electrodes 32 and 33 are formed, connecting to the semiconductor element 31. For the electrodes 32 and 33, the number of the electrodes is freely selected, although an example with two electrodes is illustrated in the drawing. The outermost layer of the semiconductor element 31 is sealed with a sealing layer (not shown) containing an epoxy resin or the like except for the portions of the electrodes 32 and 33. The electrodes 32 and 33 are electrically connected and fixed to the wiring connection parts 12.

The electronic element 40 includes a semiconductor element 41. The semiconductor element 41 is an inorganic semiconductor element containing an active element and has, for example, a configuration in which a semiconductor chip including a MOS transistor or the like formed in the semiconductor chip is mounted in a lead frame, the semiconductor chip and the lead are connected with a bonding wire, and the periphery of the semiconductor chip and the bonding wire is covered and sealed with a sealing layer (not shown) containing an epoxy resin or the like. The semiconductor element 41 may be configured to include a TFT. As illustrated in FIG. 2, lead electrodes 42 and 43 are configured to extend outward from the semiconductor element 41. For the lead electrodes 42 and 43, the number of the lead electrodes is freely selected, although an example with six lead electrodes is illustrated in the drawing. The electrodes 42 and 43 are electrically connected and fixed to the wiring connection parts 12.

### Organic semiconductor element

The electronic element 50 includes a semiconductor element 52 provided on a substrate 51. The electronic element 52 is an organic semiconductor element including either an active element, such as a transistor and an integrated circuit; or a passive element, such as a resistance element and a sensor. The semiconductor element 52 may include an active element and a passive element. The semiconductor element 52 includes an organic thin film transistor (OTFT) configured by laminating a gate electrode via a gate insulating film in an active region provided in an organic semiconductor film and forming a source drain region to sandwich the active region at both sides of the gate electrode. Raised electrodes 53 and 54, such as bumps, are formed to be connected to the semiconductor element 52. For the electrodes 53 and 54, the number of the electrodes is freely selected, although an example with six electrodes is illustrated in the drawing. The outermost layer of the semiconductor element 52 is sealed with a sealing layer (not shown) including a barrier film, a fluorocarbon resin, or the like except for the portions of the electrodes 53 and 54. The electrodes 53 and 54 are electrically connected and fixed to the wiring connection parts 12.

The semiconductor element 52 is formed by forming a transistor with a thin film transistor and further forming an active region of the thin film transistor with an organic semiconductor film. Unlike existing silicon semiconductors, the semiconductor element in which the active region is formed of an organic semiconductor film can be manufactured by a coating and printing process in the atmosphere. The configuration in which the active region of the thin film transistor is thus formed with an organic semiconductor can be manufactured by a very simple process and thus can also be applied to a wide variety of products in small quantities, and further, the devices can be introduced at a very low cost.

Examples of the technique for forming the organic semiconductor film with an organic semiconductor include a physical vapor deposition (PVD) method represented by a vacuum vapor deposition method; a plate printing method and non-plate printing method using an ink containing an organic semiconductor material; and an edge-casting method and continuous edge-casting method using a solution in which an organic semiconductor material is dissolved. An edge-casting method is described in detail, for example, in JP 2015-185620 A, and a continuous edge-casting method is described in detail, for example, in JP 2017-147456 A. When a PVD method or a continuous edge-casting method is used, the organic semiconductor film is formed on the entire surface of the upper surface of the insulating film, and then the shape of the organic semiconductor film may be patterned by photolithography or the like; or the organic semiconductor film may be formed in a state where the shape of the organic semiconductor is patterned using a mask. The organic semiconductor film is preferably a single crystal film of the organic semiconductor.

Examples of the material for an n-type organic semiconductor film include
N,N'-di((S)-1-methylpentyl)-1,7(6)-dicyano-perylene-3,4:9,10-bis-(dicarboxim ide) (PDI1MPCN2), N-fluoroalkylated dicyanoperylene-3,4:9,10-bis(dicarboximides) (PDI-FCN₂), N,N'-dioctyl perylene diimide (PDI-C8), N,N'-ditridecyl perylene diimide) (PDI-C13),
N,N'-bis(n-octyl),1,6-dicyanoperylene-3,4:9,10-bis(dicarboximide) (PDI-8CN₂), fluoro-substituted perylene tetracarboxylic acid bisimide (PBI) derivatives (PBI-F₂, PBI-F₄), copper hexadecafluoro phthalocyanine (F₁₆CuPc), tetra-chloroperylene tetracarboxyldiimide (TC-PTCDI),
N,N'-bis(2-phenylethyl)perylene-3,4:9:10-bis-(dicarboximide) (BPE-PTCDI), and
2,9-diphenethylanthra[9,1,2-cde:10,5,6-c'd'e']bis([2,7]naphthyridine)-1,3,8,10(2 H,9H)-tetraone.

In addition, examples of the material that can be vapor-deposited into a film and used as the material for a p-type organic semiconductor film include pentacene and copper phthalocyanine. Furthermore, examples of the material that can be formed into a film by a plate printing method, non-plate printing method, or edge-casting method and used as the material for a p-type organic semiconductor film include pentacene precursors, represented by 6,13-bis(triisopropylsilylethynyl)pentacene (Tips-Pentacene), 13,6-N-sulfinylacetamidopentacene (NSFAAP), 6, 13-Dihydro-6, 13-methanopentacene-15-one (DMP), pentacene-N-sulfinyl-n-butylcarbamate adducts, and pentacene-N-sulfinyl-tert-butylcarbamate; low molecular weight compounds or oligomers represented by [1]benzothieno[3,2-b]benzothiophene (BTBT), 3,11-didecyldinaphto[2,3-d:2',3'-d']benzo[1,2-b:4,5-b']dithiophene (C10-DNBDT) and C9-DNBDT with different side chain length from that of C10-DNBDT, those having a benzobisthiazole backbone, porphyrin, benzoporphyrin, and oligothiophene having an alkyl group as a soluble group; and macromolecular compounds represented by polythiophene, fluorene copolymers, indacenodithiophene benzothiadiazole (IDT-BT) having a D-A structure, and cyclopentadithiophene benzothiadiazole (CDT-BT).

The organic semiconductor film, which is an active region, is also preferably formed of a semiconductor containing a metal compound, such as a carbon nanotube, graphene, an oxide semiconductor, or black phosphorus. The thin film transistor with an active region containing a carbon nanotube is described in detail, for example, in JP 6005204 B; Dong-ming Sun et al., "Flexible high-performance carbon nanotube integrated circuits", Nature Nanotechnology volume 6, pages 156-161 (2011); Donglai Zhong et al., "Gigahertz integrated circuits based on carbon nanotube films", Nature Electronics volume 1, pages 40-45 (2018); and Jianshi Tang et al., "Flexible CMOS integrated circuits based on carbon nanotubes with sub-10ns stage delays", Nature Electronics volume 1, pages 191-196 (2018).

The thin film transistor with an active region containing graphene is described in detail, for example, in JP 2013-253010 A; Seunghyun Lee1 et al., "Flexible and Transparent All-Graphene Circuits for Quaternary Digital Modulations", Nature Communications volume 3, Article number: 1018 (2012); Shu-Jen Han1 et al., "Graphene radio frequency receiver integrated circuit", Nature Communications volume 5, Article number: 3086 (2014); and Yu-Ming Lin et al., "Wafer-Scale Graphene Integrated Circuit", Science 10 Jun 2011, Vol. 332, Issue 6035, pp. 1294-1297.

The thin film transistor with an active region containing an oxide semiconductor is described in detail, for example, in JP 2017-76789 A; JP 2018-50043 A; Hiroaki Ozakia et al., "Wireless operations for 13.56-MHz band RFID tag using amorphous oxide TFTs", IEICE Electronics Express Volume 8 (2011) Issue 4, Pages 225-231; Ming-Hao Hung et al., "Ultra Low VoltageI-V RFID Tag Implement in aIGZO TFT Technology on Plastic", 2017 IEEE International Conference on RFID (RFID); and Byung-Do Yang et al., "A Transparent Logic Circuit for RFID Tag in α-IGZO TFT Technology", ETRI Journal Volume 35, Issue 4, August 2013, Pages 610-616.

The thin film transistor with an active region containing black phosphorus is described in detail, for example, in JP 2018-14359 A; JP 2018-98338 A; Xuewei Feng et al., "Complementary Black Phosphorus Nanoribbons Field-Effect Transistors and Circuits", IEEE Transactions on Electron Devices Volume 65, Issue 10, Oct. 2018, Page(s): 4122 -4128; and Peng Wu et al., "High Performance Complementary Black Phosphorus FETs and Inverter Circuits Operating at Record-Low VDD down to 0.2V", 2018 76th Device Research Conference (DRC).

The electronic elements 20, 30, 40, and 50 of the present embodiment are not particularly limited to the following but are electrically connected to the wiring connection parts preferably without interposition of a material (e.g., another conductive paste different from the conductive paste constituting the wiring connection parts 12) other than a material (e.g., a given conductive paste) constituting solder and the wiring connection parts 12 between the wiring connection parts 12 and the electrode of each of the electronic elements 20, 30, 40, and 50.

### Resin film

In the semiconductor device 1 of the present embodiment, the resin film 60 includes two resin films 60A and 60B. The resin film 60A is laminated on one surface of the substrate 10, conforming to the shapes of the electronic elements 20, 30, 40, and 50 and covering the electronic elements 20, 30, 40, and 50. The resin film 60B is further laminated on the other surface of the substrate 10. The thickness of the resin films 60A and 60B is, for example, 10 µm or greater and 300 µm or less. The resin films 60A and 60B are formed, for example, of poly(ethylene terephthalate) (PET), polystyrene (PS), polyamide (PA), polyethylene (PE), polypropylene (PP), polyvinyl chloride (PVC), polymethyl methacrylate (PMMA), or the like. The resin film 60A conforms to the shapes of the electronic elements 20, 30, 40, and 50 and covers the electronic elements 20, 30, 40, and 50, but gaps may be left between the substrate 10 and the electronic elements 20, 30, 40, and 50. Here, the gaps are spaces present between the substrate 10 and the electronic elements 20, 30, 40, and 50; the spaces are present on the back side of the electronic elements 20, 30, 40, and 50 as viewed from the resin film 60A and thus are difficult to fill with the film 60A. Some air bubbles may remain between the substrate 10 and the resin films 60A and 60B, but adhesions between the substrate 10 and the resin films 60A and 60B are increased with reduced air bubbles, and thus the air bubbles are preferably reduced. Here, the air bubbles are spaces present between the substrate 10 and the resin films 60A and 60B and not completely filled with the resin films 60A and 60B. The air bubbles left between the substrate 10 and the resin films 60A and 60B decrease with increased conformability of the resin films 60A and 60B. As described later, the degree of the amount of air bubbles left between the substrate 10 and the resin films 60A and 60B can be controlled by the lamination method and lamination conditions of the resin films 60A and 60B.

### Method of manufacturing semiconductor device

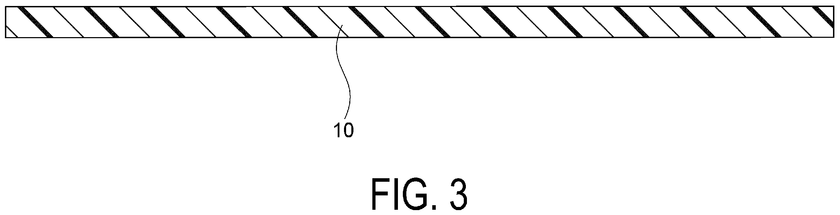

A method of manufacturing a semiconductor device of the present embodiment will be described with reference to FIG. 3 to FIG. 6 below. FIG. 3 to FIG. 6 illustrate each process in the method of manufacturing a semiconductor device of the present embodiment and are cross-sectional views corresponding to FIG. 2. First, as illustrated in FIG. 3, the substrate 10 is prepared. Here, for example, a flexible substrate is prepared as the substrate 10.

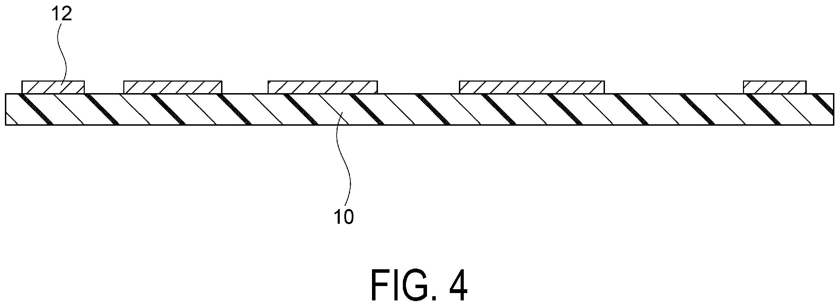

Next, as illustrated in FIG. 4, for example, the conductive paste is printed by screen printing or the like, and uncured wirings 11A and uncured wiring connection parts 12A connected to the wirings 11A are formed on the substrate 10. The wirings 11A and the wiring connection parts 12A are preferably formed of the same material and more preferably formed, for example, with the same thickness. This enables the wirings 11A and the wiring connection parts 12A to be formed simultaneously by one manufacturing process. For example, the conductive paste to be turned into the wirings 11A and the wiring connection parts 12A is printed with a predetermined thickness of 1 µm or greater and 300 µm or less. The conductive paste printed in a predetermined wiring pattern is cured and can be turned into a conductive layer in a predetermined pattern, that is, the wirings 11 and the wiring connection parts 12. Here, the conductive paste with high viscosity and viscoelasticity is used. The viscosity is, for example, 20 Pa·s or higher and more preferably 100 Pa·s or higher. When the conductive paste is printed by another printing method, such as spray printing, the conductive paste with a viscosity suitable for each printing method is used. For example, the viscosity for spray printing is preferably 5 Pa·s or lower and, for example, 0.5 Pa·s.

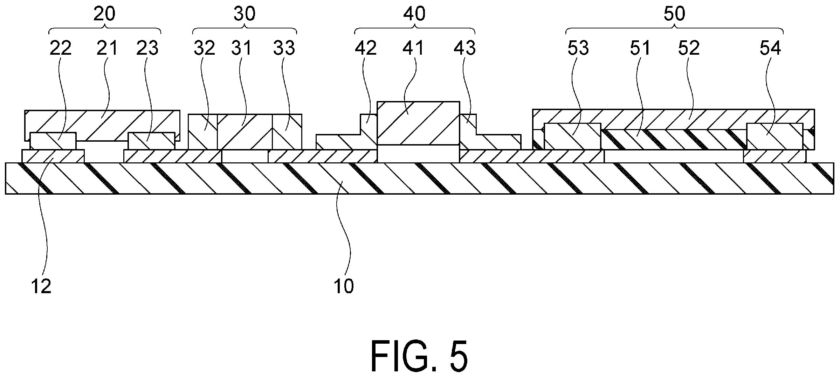

In the method of manufacturing a semiconductor device of the present embodiment, before curing the conductive paste printed as described above, the electronic elements 20, 30, 40, and 50 are placed on the wiring connection parts 12A as illustrated in FIG. 5. For example, the electronic elements 20, 30, 40, and 50 are each sucked with a suction collet and placed in predetermined positions to bring each electrode of the electronic elements 20, 30, 40, and 50 into contact with the upper surfaces of the wiring connection parts 12A. The electronic elements 20, 30, 40, and 50 are temporarily fixed on the wiring connection parts 12A by viscosity and viscoelasticity of the conductive paste.

Then, curing treatment, such as firing, light irradiation, or drying, is performed to cure the wirings 11A and wiring connection parts 12A containing the uncured conductive paste. For a thermosetting conductive paste, for example, the whole is fired at 130°C or lower (100°C or lower according to the type of conductive paste). For a photocurable conductive paste, the paste is irradiated with light of a wavelength in the visible to ultraviolet region. This can turn the conductive paste into a cured conductive layer, and along with the curing of the conductive paste, further can fix the electronic elements 20, 30, 40, and 50 to the wiring connection parts 12 while electrically connecting the electronic elements to the wiring connection parts 12 obtained by curing.

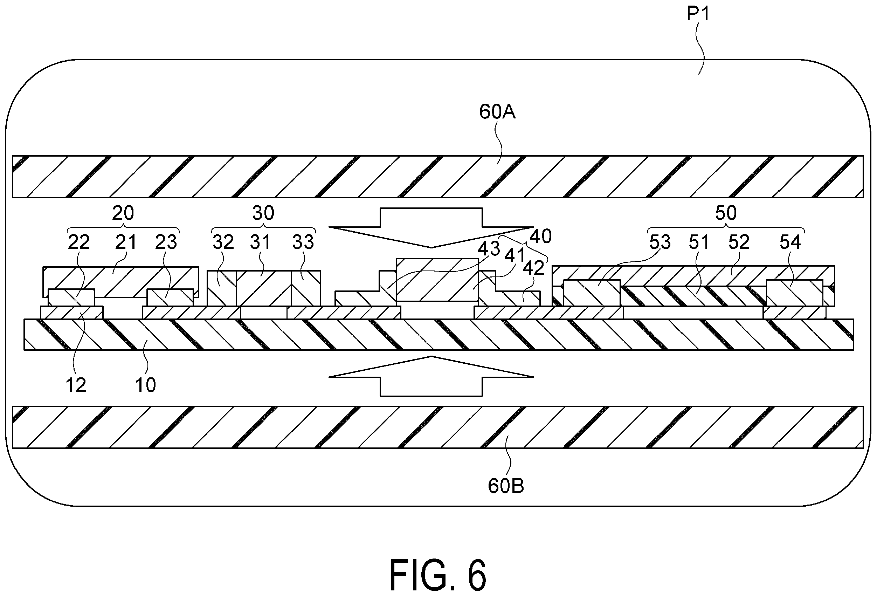

Next, as illustrated in FIG. 6, the resin film 60A is laminated on one surface of the substrate 10, conforming to the shapes of the electronic elements 20, 30, 40, and 50 and covering the electronic elements 20, 30, 40, and 50. Furthermore, the resin film 60B is laminated on the other surface of the substrate 10 simultaneously with the lamination of the resin film 60A. In the present embodiment, the resin films 60A and 60B are laminated on the substrate 10 in a vacuum or reduced pressure space indicated by a pressure P1. Laminating the resin films 60A and 60B in a vacuum or reduced pressure space is capable of improving the adhesions between the substrate 10 and the resin films 60A and 60B by the pressure difference when the resulting laminate is taken out to the atmospheric pressure. As a result, laminating the resin films 60A and 60B in a vacuum or reduced pressure space can reduce the air bubbles left between the substrate 10 and the resin films 60A and 60B and is capable of improving the adhesions between the substrate 10 and the resin films 60A and 60B more than laminating the resin films 60A and 60B in the atmosphere.

Of the regions where the substrate 10 and the resin film 60A face each other except for the regions of the electronic elements 20, 30, 40, and 50, that is, of the regions that can be adhered to the substrate 10 depending on the conformability of the resin film 60A, the proportion of the region actually adhered to the substrate 10 is defined as the proportion of the adhesion region. Reducing the air bubbles left between the substrate 10 and the resin films 60A and 60B increases the proportion of the adhesion region. The proportion of the adhesion region is preferably 80% or higher and more preferably 90% or higher. On the back surface side of the substrate 10, where the electronic elements 20, 30, 40, and 50 are not mounted, the proportion of the adhesion region between the resin film 60B and the substrate 10 is approximately 100% although this depends on the presence or absence of the wiring pattern or the like.

### Actions and effects

In the semiconductor device of the present embodiment, the resin film is laminated on one surface of the substrate, conforming to the shapes of the electronic elements and covering the electronic elements, and this is capable of improving the connection reliability between the electronic elements and the substrate. In particular, when the substrate is a flexible substrate, the connection reliability tends to decrease due to the effects of bending of the substrate and vibration of the substrate, but the semiconductor device of the present embodiment can improve bending resistance, vibration resistance, and scratch resistance, and is capable of improving the connection reliability.

Using a flexible substrate as the substrate can reduce weight and cost than using a rigid substrate but may reduce the rigidity of the semiconductor device. Laminating the resin film as in the present embodiment is capable of improving the rigidity of the entire semiconductor device. In addition, a flexible substrate is thinner than a rigid substrate and thus has an advantage of high heat dissipation and thermal conductivity. Especially for a semiconductor device in which an electronic element consuming a large current is mounted, heat dissipation is preferably higher. Furthermore, for example, for a semiconductor device in which a temperature sensor is mounted, thermal conductivity is preferably higher in terms of measuring the temperature of the object.

In the method of manufacturing a semiconductor device of the present embodiment, the conductive paste is printed, the electronic elements are placed, and the conductive paste is cured. This enables the wirings and the wiring connection parts to be formed simultaneously and the electronic elements to be fixed to the wiring connection parts obtained by curing while electrically connecting the electronic elements to the wiring connection parts.

In the method of manufacturing a semiconductor device of the present embodiment, a printing process of solder is not performed, and thus this can reduce the number of processes. In addition, the method can omit the alignment adjustment of the wiring pattern and the solder printing and thus can simplify the process. Furthermore, the method does not use solder and thus can avoid the bonding problem between the wiring metal material and the solder due to the oxide film. Moreover, the method can achieve fixing and conduction of the electronic elements by low temperature treatment at 130°C. This eliminates a high temperature process and thus enables a low thermal resistance material to be selected for the substrate. That is, this enables the method to use a general-purpose resin film, such as PEN, PET, PLA, an epoxy resin, or an acrylic resin, having lower thermal resistance than polyimide. Thus, this enables the method to employ a film of these as an inexpensive, colorless and transparent flexible substrate. In addition, the method can reduce the risk of thermal damage to an organic semiconductor element, such as an OTFT, by the mounting process.

The wirings 11 and the wiring connection parts 12 can be formed by applying the conductive paste in a predetermined pattern by printing, such as inkjet printing, spray printing, or screen printing. Screen printing is a technique capable of inexpensively and simply patterning the conductive paste and has merits below in wiring the circuit, and thus the wirings 11 and the wiring connection parts 12 are formed preferably by screen printing.

Screen printing makes it possible to increase the thickness of the printing pattern to 10 µm or greater and can reduce the wiring resistance. In addition, the device and the plate are inexpensive, the paste used for printing can be recovered, thus the loss is small, and low cost can be achieved. The particle size of the conductive filler that can be used is in a wide range of 0.1 µm or greater and several tens of micrometers or less, providing a wide range of options for the conductive paste. Screen printing enables printing on films, fabrics, glass, metals, and the like, providing a wide range of options for objects on which the conductive paste is to be printed. For the curing treatment of the conductive paste, the paste can be fired at a low temperature of 130°C or lower or even at a temperature lower than 100°C depending on the type of paste. Screen printing enables laminate printing, which provides an insulating layer between a plurality of layers of conductive paste, and this can achieve multi-layer wiring and can also achieve an intersecting wiring pattern. Screen printing can achieve an accuracy of line/space of 50 µm/50 µm, having a practical level of accuracy in wiring of the electronic circuit. Screen printing enables printing from the millimeter scale up to the meter scale and can be applied to various sizes.

Screen printing includes a method using a metal mask and a method using a mesh screen, and printing may be performed by either method. The method using a mesh screen has the following merits. The pattern accuracy is higher than that of the method using a metal mask. A pattern with dense lines and a hollow pattern can be printed. The plate is highly durable and can be used repeatedly and thus is suitable for mass production.

### Second embodiment

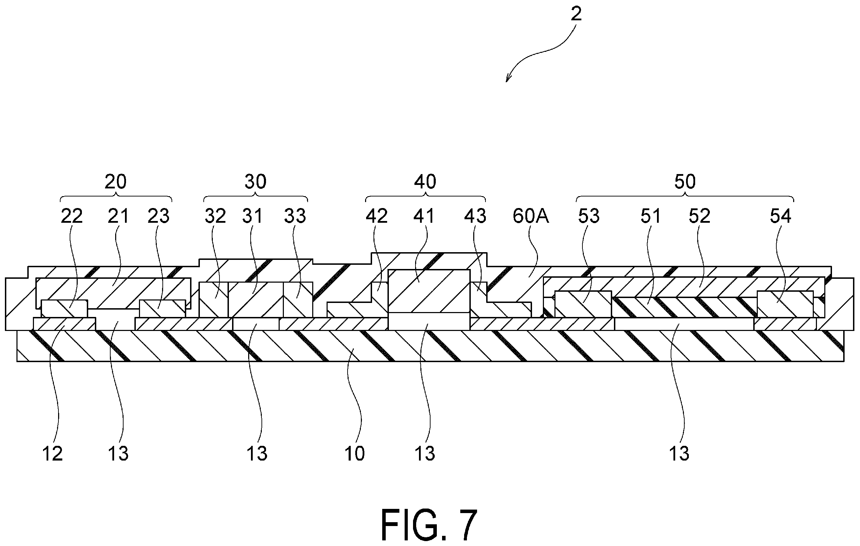

FIG. 7 is a cross-sectional view of a semiconductor device according to the present embodiment. In the semiconductor device 2 of the present embodiment, the resin film 60A is laminated only on one surface side of the substrate 10 on which the electronic elements 20, 30, 40, and 50 are mounted to conform to the shapes of the electronic elements 20, 30, 40, and 50 and cover the electronic elements 20, 30, 40, and 50. The resin film is not laminated on the other surface of the substrate 10. Except for the above, others are the same as in the first embodiment.

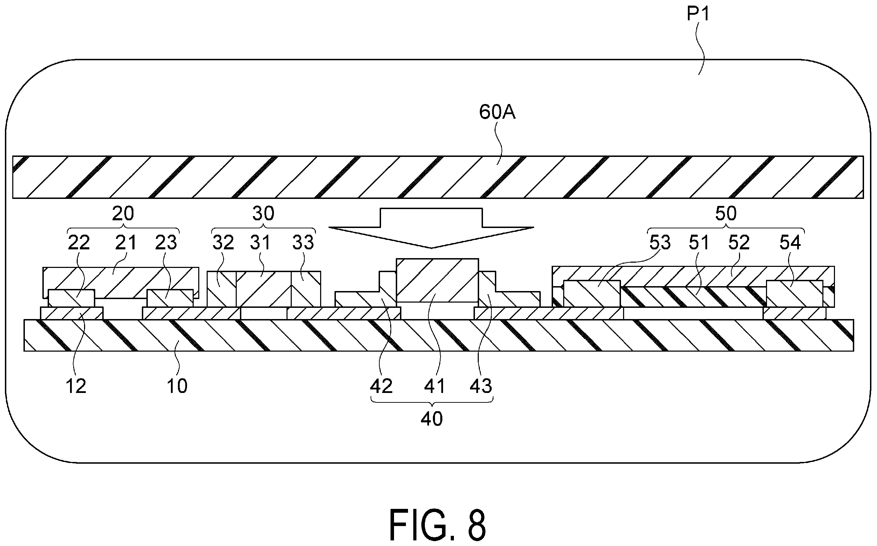

FIG. 8 is a cross-sectional view illustrating a process of a method of manufacturing a semiconductor device of the present embodiment. In the same manner as in the first embodiment, wirings and a conductive paste to be turned into wiring connection parts are printed on a substrate, electronic elements are placed, and the conductive paste is cured, and then in a process of laminating a resin film, the resin film 60A is laminated only on one surface side of the substrate 10 on which the electronic elements 20, 30, 40, and 50 are mounted to conform to the shapes of the electronic elements 20, 30, 40, and 50 and cover the electronic elements 20, 30, 40, and 50. The resin film is not laminated on the other surface of the substrate 10. Except for the above, others are the same as in the first embodiment.

In the semiconductor device of the present embodiment, the resin film is laminated on one surface of the substrate, conforming to the shapes of the electronic elements and covering the electronic elements, and this is capable of improving the connection reliability between the electronic elements and the substrate. In particular, when the substrate is a flexible substrate, the connection reliability tends to decrease due to the effects of bending of the substrate and vibration of the substrate, but the semiconductor device of the present embodiment can improve bending resistance, vibration resistance, and scratch resistance, and is capable of improving the connection reliability.

### First modified example

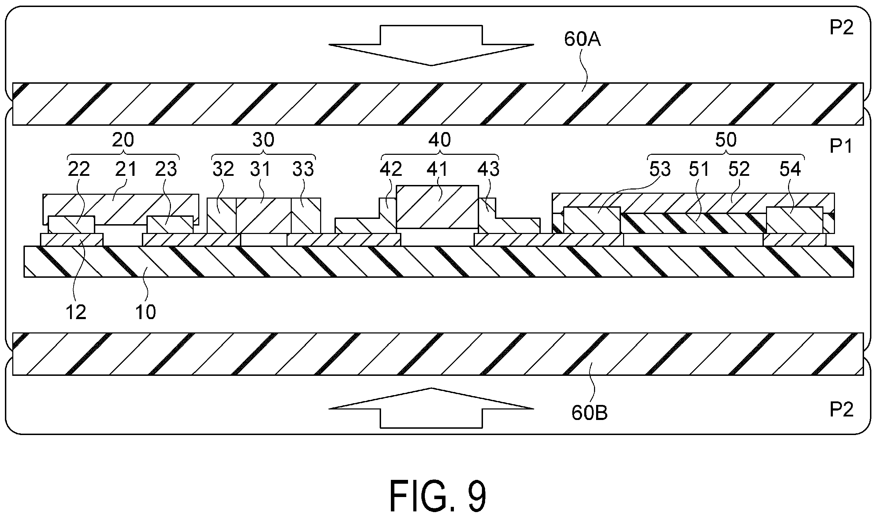

FIG. 9 is a cross-sectional view illustrating a process of a method of manufacturing a semiconductor device of the present modified example. As illustrated in FIG. 9, in a process of laminating the resin film 60A on one surface of the substrate 10 and laminating the resin film 60B on the other surface of the substrate 10, the resin films 60A and 60B are laminated on one surface and the other surface of the substrate 10 in a state where a pressure P1 in a space on the substrate 10 sides of the resin films 60A and 60B is lower than pressures P2 in spaces on the opposite sides of the resin films 60A and 60B from the substrate 10. That is, the pressure of each space divided by the resin films 60A and 60B is adjusted by a three-dimensional overlay method (TOM) method. For example, the space on the substrate 10 sides of the resin films 60A and 60B is in a vacuum or reduced pressure atmosphere, and the spaces on the opposite sides of the resin films 60A and 60B from the substrate 10 are in an atmospheric pressure or pressurized atmosphere. Except for the above, others are the same as in the first embodiment.

The resin films 60A and 60B are laminated by the TOM method as described above, that is, the resin films 60A and 60B are laminated in a state where the pressure in a space on the substrate sides of the resin films 60A and 60B is lower than the pressures in spaces on the opposite sides of the resin films 60A and 60B from the substrate, and this can eliminate almost all air bubbles left between the substrate 10 and the resin films 60A and 60B. The proportion of the adhesion region between the substrate 10 and the resin film 60A is increased and is 95% or higher. This increases the conformability of the resin film 60A to the electronic elements 20, 30, 40, and 50 and increases the adhesion of the resin film 60 to the electronic elements 20, 30, 40, and 50 and the substrate 10. On the back surface side of the substrate 10, where the electronic elements 20, 30, 40, and 50 are not mounted, the proportion of the adhesion region between the resin film 60B and the substrate 10 is approximately 100% although this depends on the presence or absence of the wiring pattern or the like.

### Second modified example

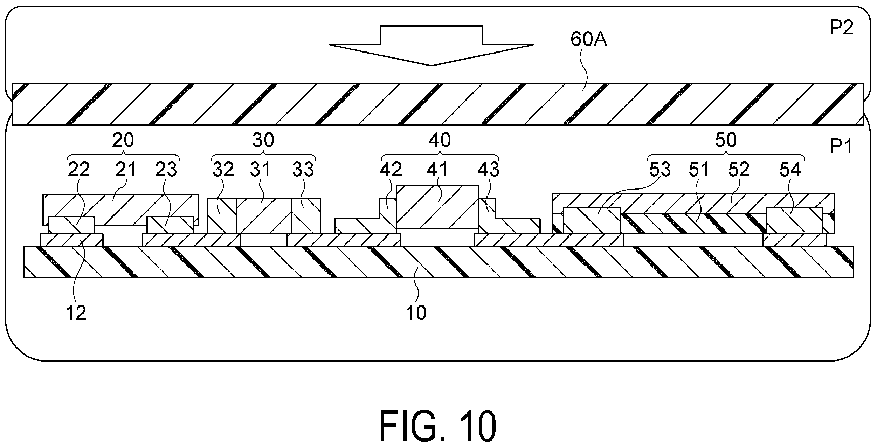

FIG. 10 is a cross-sectional view illustrating a process of a method of manufacturing a semiconductor device of the present modified example. As illustrated in FIG. 10, in a process of laminating the resin film 60A on one surface of the substrate 10, the resin film 60A is laminated on one surface of the substrate 10 in a state where a pressure P1 in a space on the substrate 10 side of the resin film 60A is lower than a pressure P2 in a space on the opposite side of the resin film 60A from the substrate 10. The pressure of each space divided by the resin film 60A is adjusted by the TOM method in the same manner as in the first modified example. For example, the space on the substrate 10 side of the resin film 60A is in a vacuum or reduced pressure atmosphere, and the space on the opposite side of the resin film 60A from the substrate 10 is in an atmospheric pressure or pressurized atmosphere. Except for the above, others are the same as in the second embodiment.

The resin film 60A is laminated by the TOM method as described above, that is, the resin film 60A is laminated in a state where the pressure in a space on the substrate side of the resin film 60A is lower than the pressure in a space on the opposite side of the resin film 60A from the substrate, and this can eliminate almost all air bubbles left between the substrate 10 and the resin film 60A. This increases the conformability of the resin film 60A to the electronic elements 20, 30, 40, and 50 and increases the adhesion of the resin film 60 to the electronic elements 20, 30, 40, and 50 and the substrate 10.

### First example

A thermosetting silver paste (viscosity 130 Pa·s) was screen-printed on a film-shaped substrate (thickness 50 µm) containing polyimide (PI) using a metal mask (thickness 50 µm), and uncured wirings and wiring connection parts were formed. Resistors were placed on the uncured wiring connection parts and fired at 130°C for 30 minutes, and the uncured wirings and the uncured wiring connection parts were cured. As described above, a module in which the wirings and wiring connection parts were formed on the substrate and the resistors were mounted was produced.

The module was able to achieve an accuracy of L/S of 200 µm/200 µm as the accuracy of line/space of the wirings. The resistance values on the circuit were measured with a tester to confirm that the measurements were the resistance values specified for the resistors, confirming that the conduction between the resistors and the wirings and wiring connection parts was maintained. The following load tests were performed: a test of applying a bending with a radius of curvature of 10 mm to the substrate (hereinafter referred to as the "bending test"), a test of generating a 100-Hz sine wave using a vibrator and applying an accelerated vibration of approximately 10 G to the substrate for 2 hours (hereinafter referred to as the "vibration test"), or a test of scratching the resistors (specifically pressing the resistors with the tips of tweezers) (hereinafter, the test of scratching electronic elements, such as resistors, is referred to as the "scratch test"). When each load test was performed, the registers did not come off. Furthermore, a cross-cut test of the wiring portions performed to evaluate the degree of adhesion of the silver paste was performed, but the peeled portion was not observed.

On the module in which the wirings and wiring connection parts were formed on the substrate and the resistors were mounted, PET films with a thickness of 50 µm were laminated on both sides of the module in vacuum. On the resistor-mounted surface, the PET film was laminated, conforming to the shapes of the resistors and covering the resistors. This was able to further increase the connection reliability between the resistors and the wirings and wiring connection parts.

### Second example

A thermosetting silver paste (viscosity 130 Pa·s) was screen-printed on a film-shaped substrate (thickness 125 µm) containing poly(ethylene naphthalate) (PEN) using a metal mask (thickness 50 µm), and uncured wirings and wiring connection parts were formed. Seven temperature sensors were placed on the uncured wiring connection parts and fired at 130°C for 30 minutes, and the uncured wirings and the uncured wiring connection parts were cured. As described above, a module in which the wirings and wiring connection parts were formed on the substrate and seven temperature sensors were mounted was produced.

The module was able to achieve an accuracy of L/S of 350 µm/150 µm as the accuracy of line/space of the wirings. A measurement confirmed that the outputs of the temperature sensors on the circuit changed depending on the environmental temperature, confirming that the conduction between the temperature sensors and the wirings and wiring connection parts was maintained. When each load test, the bending test, the vibration test, or the scratch test on the temperature sensors, was performed, the temperature sensors did not come off.

On the module in which the wirings and wiring connection parts were formed on the substrate and the temperature sensors were mounted, PET films with a thickness of 50 µm were laminated on both sides of the module in vacuum. On the temperature sensor-mounted surface, the PET film was laminated, conforming to the shapes of the temperature sensors and covering the temperature sensors. This was able to further increase the connection reliability between the temperature sensors and the wirings and wiring connection parts.

### Third example

A thermosetting carbon paste (viscosity 0.5 Pa·s) was screen-printed on a film-shaped substrate (thickness 50 µm) containing polyimide (PI) using a metal mask (thickness 50 µm), and wirings and wiring connection parts were formed. The carbon paste was separately supplied to connect resistors to the wiring connection parts, and a module in which the resistors were mounted on the substrate on which the wirings and wiring connection parts were formed was formed.

The module obtained as described above was able to achieve an accuracy of L/S of 200 µm/200 µm as the accuracy of line/space of the wirings. The resistance values on the circuit were measured with a tester to confirm that the measurements were the resistance values specified for the resistors, confirming that the conduction between the resistors and the wirings and wiring connection parts was maintained. When the load test, the bending test or the vibration test, was performed on the module, the resistors did not come off. However, when the scratch test on temperature sensors or a test of bonding temperature sensors with a bonding tape (bonding strength 3.93 N/10 mm) was performed, the resistors came off.

On the module in which the wirings and wiring connection parts were formed on the substrate and the resistors were mounted, PET films with a thickness of 50 µm were laminated on both sides of the module in vacuum. On the resistor-mounted surface, the PET film was laminated, conforming to the shapes of the resistors and covering the temperature sensors. Laminating the PET film in a vacuum atmosphere as in the present example reduced air bubbles between the substrate and resistors and the PET film more than laminating the PET film in the atmosphere. Thus, this increased the adhesion between the PET film and the substrate and resistors. When the load test, the bending test or the vibration test, was performed on the module of the present example in which the PET films were laminated, the resistors did not come off. In addition, for the module of the present example in which the PET films were laminated, when the scratch test on temperature sensors or a test of bonding temperature sensors with a bonding tape (bonding strength 3.93 N/10 mm) was performed, the resistors did not come off. This was thus able to further increase the connection reliability between the resistors and the wirings and wiring connection parts.

### Fourth example

On the module described in the third example in which the wirings and wiring connection parts were formed on the substrate and the resistors were mounted, PET films with a thickness of 50 µm were laminated on both sides of the module in vacuum. Here, in a process of laminating the PET films, the PET films were laminated in a state where a space on the module sides of the PET films was in a vacuum atmosphere and spaces on the opposite sides of the PET films from the module were in an atmospheric atmosphere. On the resistor-mounted surface, the PET film was laminated, conforming to the shapes of the resistors and covering temperature sensors. Here, as a result of laminating the PET films in a state where the space on the module side of the PET films was in a vacuum atmosphere and the spaces on the opposite sides of the PET films from the module were in an atmospheric atmosphere as described above, almost no air bubble remained between the substrate and resistors and the PET film. On the resistor-mounted surface side of the substrate, the proportion of the adhesion region between the substrate and the PET film was increased and was 95%. Thus, this further increased the adhesion between the PET film and the substrate and resistors. For the module of the present example in which the PET films were laminated, when the bending test, the vibration test, the scratch test on temperature sensors, or a test of bonding temperature sensors with a bonding tape (bonding strength 3.93 N/10 mm) was performed, the resistors did not come off. This was thus able to further increase the connection reliability between the resistors and the wirings and wiring connection parts.

In the embodiments and modified examples described above, semiconductor devices in which a plurality of electronic elements is mounted have been described, but the semiconductor device is not limited to these and may be a semiconductor device in which only one electronic element is mounted. For the electronic element, electronic elements containing an active element, such as a transistor, and electronic elements containing a passive element, such as a resistance element, have been described, but the electronic element may be an electronic element containing an active element and a passive element in one chip.

### Reference Signs List

1, 2: Semiconductor device
10: Substrate
11: Wiring
12: Wiring connection part
20, 30, 40, 50: Electronic element
21, 31, 41, 52: Semiconductor element
22, 23, 32, 33, 53, 54: Electrode
42, 43: Lead electrode
51: Substrate
60, 60A, 60B: Resin film

## Claims

1. A semiconductor device comprising:
a substrate provided with a wiring and a wiring connection part connected to the wiring;
an electronic element electrically connected to the wiring connection part and fixed to the substrate; and
a resin film laminated on one surface of the substrate, the resin film conforming to a shape of the electronic element and covering the electronic element.

2. The semiconductor device according to claim 1, wherein the substrate is a flexible substrate.

3. The semiconductor device according to claim 1 or 2, wherein the wiring and the wiring connection part are formed of the same material.

4. The semiconductor device according to claim 3, wherein the wiring and the wiring connection part are formed with the same thickness.

5. The semiconductor device according to any one of claims 1 to 4, wherein the electronic element comprises an organic semiconductor element.

6. The semiconductor device according to any one of claims 1 to 5, wherein the substrate is a multilayer wiring substrate.

7. The semiconductor device according to any one of claims 1 to 6, wherein the resin film is further laminated on the other surface of the substrate.

8. A method of manufacturing a semiconductor device, the method comprising:
providing a substrate with a wiring and a wiring connection part connected to the wiring;
electrically connecting an electronic element to the wiring connection part and fixing the electronic element to the substrate; and
laminating a resin film on one surface of the substrate, the resin film conforming to a shape of the electronic element and covering the electronic element.

9. The method of manufacturing a semiconductor device according to claim 8, wherein the substrate is a flexible substrate.

10. The method of manufacturing a semiconductor device according to claim 8 or 9, wherein the wiring and the wiring connection part are formed simultaneously in the step of providing a substrate with a wiring and a wiring connection part connected to the wiring.

11. The method of manufacturing a semiconductor device according to claim 10, wherein the wiring and the wiring connection part are formed by printing in the step of providing a substrate with a wiring and a wiring connection part connected to the wiring.

12. The method of manufacturing a semiconductor device according to any one of claims 8 to 11, wherein the resin film is laminated on one surface of the substrate in a vacuum or reduced pressure space in the step of laminating a resin film on one surface of the substrate.

13. The method of manufacturing a semiconductor device according to any one of claims 8 to 11, wherein the resin film is laminated on one surface of the substrate in a state where a pressure in a space on the substrate side of the resin film is lower than a pressure in a space on the opposite side of the resin film from the substrate in the step of laminating a resin film on one surface of the substrate.
